Europäisches Patentamt

European Patent Office

Office européen des brevets

(19)

(11) Veröffentlichungsnummer: **0 212 760**
**A2**

# EUROPÄISCHE PATENTANMELDUNG

(12)

(21) Anmeldenummer: 86201455.2

(22) Anmeldetag: 22.08.86

(51) Int. Cl.⁴: **H03F 1/02** , H03F 3/217 , G01R 33/22

(30) Priorität: 28.08.85 DE 3530637

(43) Veröffentlichungstag der Anmeldung:
04.03.87 Patentblatt 87/10

(84) Benannte Vertragsstaaten:
DE FR GB NL

(71) Anmelder: Philips Patentverwaltung GmbH
Billstrasse 80
D-2000 Hamburg 28(DE)
Anmelder: N.V. Philips' Gloeilampenfabrieken
Groenewoudseweg 1
NL-5621 BA Eindhoven(NL)

(72) Erfinder: van der Zwart, Alfred J.
Nieuwstraat 82
NL-5521 CE Eersel(NL)

(74) Vertreter: Hartmann, Heinrich, Dipl.-Ing. et al
Philips Patentverwaltung GmbH Billstrasse
80 Postfach 10 51 49
D-2000 Hamburg 28(DE)

(54) Schaltungsanordnung mit einer an den Ausgang eines Verstärkers angeschlossenen Last.

(57) Die Erfindung betrifft eine Schaltung, bei der eine Last an den Ausgang eines Verstärkers angeschlossen ist, insbesondere die Gradienten-Spulenanordnung in einem Kernspintomographiegerät. Um die Verlustleistung in dem Verstärker zu verringern, wird die Versorgungsspannung für den Verstärker von einem Gleichspannungserzeuger geliefert, dessen Ausgangsspannung der Eingangsspannung in Stufen folgt, jedoch stets um einen gewissen Betrag größer bleibt als die der jeweiligen Eingangsspannung zugeordnete Ausgangsspannung des Verstärkers.

Fig.3

EP 0 212 760 A2

## Schaltungsanordnung mit einer an den Ausgang eines Verstärkers angeschlossenen Last

Die Erfindung betrifft eine Schaltungsanordnung mit einer an den Ausgang eines Verstärkers angeschlossenen Last und einem Spannungserzeuger, der an seinem Gleichspannungsausgang die Versorgungsspannung zumindest für die Endstufe des Verstärkers liefert.

Derartige Schaltungsanordnungen dienen beispielsweise bei einem Kernspintomographen der Erzeugung magnetischer Gradientenfelder mit Hilfe einer Gradientenspulenanordnung, die dabei die Last des Verstärkers bildet. Fig. la zeigt den bei einer solchen Gradientenspulenanordnung typischen zeitlichen Verlauf des Magnetflusses. Sieht man einmal von Wirbelstromeffekten ab, dann hat der Strom durch diese Spulenanordnung den gleichen Verlauf. Seine Amplitude beträgt dabei typischerweise 200 A.

Fig. lb zeigt den für den Stromverlauf gemäß Fig. la erforderlichen zeitlichen Verlauf der Spannung an der Gradientenspulenanordnung. Während des Stromanstiegs und des Stromabfalls müssen zwei Spannungsimpulse mit relativ hoher Amplitude (in der Größenordnung von 70 V) erzeugt werden. Zwischen diesen Impulsen muß eine Spannung anliegen, die gerade ausreicht, um die Wirkwiderstandsverlust der Spulenanordnung auszugleichen.

Die Versorgungsspannung für den die Spulenanordnung speisenden Verstärker muß geringfügig höher sein als die Spitzenspannung an der Gradientenspulenanordnung. Die Verlustleistung im Verstärker ist gegeben durch das Integral des Produktes aus dem Strom gemäß Fig. la und der Differenz zwischen der Versorgungsspannung und der Spannung gemäß Fig. lb. Sie ist besonders groß, wenn der Strom durch die Spulenanordnung groß und die Spannung an der Spulenanordnung klein ist.

Aufgabe der Erfindung ist es, eine Schaltungsanordnung der eingangs genannten Art so auszugestalten, daß die im Verstärker in Wärme umgesetzte Verlustleistung geringer ist als in dem oben beschriebenen Fall.

Diese Aufgabe wird erfindungsgemäß dadurch gelöst, daß der Spannungserzeuger mehrere Gleichspannungsquellen mit unterschiedlich großer Gleichspannung enthält sowie eine Schalteranordnung, die eine der Gleichspannungsquellen oder die Serienschaltung mehrerer Gleichspannungsquellen mit dem Gleichspannungsausgang verbindet, und daß eine Steuerschaltung vorgesehen ist, die aus dem Eingangssignal des Verstärkers eine Steuerspannung zur Steuerung der Schalteranordnung ableitet in solcher Weise, daß die Spannung am Gleichspannungsausgang der Eingangsspannung in Stufen folgt, jedoch stets um einen gewissen Betrag größer bleibt als der Betrag der mit dem Verstärkungsfaktor des Verstärkers multiplizierten Eingangsspannung.

Hierbei wird also die Schalteranordnung, die die Spannung am Gleichspannungsausgang bestimmt, so geschaltet, daß sie stets etwas größer ist als die an sich benötigte Spannung an der Last. Die Differenz zwischen der Versorgungsspannung und der Spannung an der Last ist also relativ klein, so daß auch die im Verstärker in Wärme umgesetzte Verlustleistung wesentlich kleiner ist als bei einem Konzept mit konstanter Versorgungsspannung. Die für den Verstärker erforderliche Versorgungsspannung ergibt sich aus seiner Eingangsspannung, die von der Steuerschaltung in ein Steuersignal für die Steuerschaltung umgesetzt wird. Da die Änderungsgeschwindigkeit der Versorgungsspannung nur durch die Schaltzeit der Schalter, nicht aber durch Kondensatoren oder dergleichen bestimmt ist, kann sie Änderungen der Eingangsspannung sehr schnell folgen.

Die Zahl der unterschiedlichen Versorgungsspannungen, die der gemäß Anspruch I ausgestaltete Spannungserzeuger liefern kann, ist größer als die Anzahl der Gleichspannungsquellen, weil mehrere der Gleichspannungsquellen auch in Serie geschaltet werden können, um die Versorgungsspannung zu erzeugen. Grundsätzlich könnte jede beliebige Kombination der Gleichspannungsquellen dadurch erreicht werden, daß jeder Gleichspannungsquelle ein Schalter in Serie und dieser Serienschaltung jeweils ein Schalter parallelgeschaltet wird. Dies erfordert jedoch zwei im Gegentakt geschaltete Schalter und geeignete Vorkehrungen, um zu verhindern, daß beide Schalter versehentlich gleichzeitig geschlossen würden, was einen Kurzschluß der zugehörigen Gleichspannungsquelle zur Folge hätte. Dieser Aufwand kann gemäß einer Weiterbildung dadurch reduziert werden, daß die Schalteranordnung für jede Gleichspannungsquelle einen dazu in Serie geschalteten Schalter umfaßt und daß jeder dieser Serienschaltungen eine Diode parallelgeschaltet ist, die für die zugehörige Gleichspannungsquelle in Sperrichtung betrieben ist. Immer dann, wenn ein Schalter geöffnet ist, fließt der Versorgungsstrom des Gleichspannungserzeugers über das parallelgeschaltete Diodenelement.

Eine Weiterbildung der Erfindung sieht vor, daß mindestens einer Gleichspannungsquelle ein Kondensator parallelgeschaltet ist. Diese Weiterbildung ist in.all den Fällen nützlich, in denen die betreffende Gleichspannungsquelle nur relativ kurz eingeschaltet ist. Bei der Versorgung von Gradientenspulen ist beispielsweise die Gleichspannungsquelle für die höchste Gleichspannung nur während des Stromanstiegs und der Stromabnahme eingeschaltet. Wenn der ihr parallelgeschaltetete Kondensator so bemessen ist, daß er durch den während dieser Zeiten fließenden Strom nur unwesentlich entladen wird, muß die Gleichspannungsquelle nicht diese Spitzenleistung aufbringen und braucht nur für die benötigte mittlere Leistung ausgelegt zu sein.

Eine Weiterbildung der Erfindung sieht vor, daß die Gleichspannungen jeder Gleichspannungsquelle jeweils doppelt bzw. halb so groß ist wie die nächstkleinere bzw. nächstgrößere Gleichspannung einer anderen Gleichspannungsquelle und daß die Steuerschaltung einen Analog-Digital-Wandler enthält, der ein aus dem Verstärkereingangssignal abgeleitetes Signal in ein binär codiertes Datenwort umsetzt, dessen höchstwertige Binärstellen das Steuersignal bilden, wobei jeweils die höherwertige Binärstelle die Einschaltung der Gleichspannungsquelle mit der höheren Gleichspannung bewirkt. Dabei ergibt sich ein relativ einfacher Aufbau der Steuerschaltung mittels eines Analog-Digital-Wandlers. Zusätzlich müssen lediglich noch Vorkehrungen getroffen werden, um sicherzustellen, daß die Spannung am Gleichspannungsausgang des Spannungserzeugers der Eingangsspannung in Stufen folgt, dem Betrage nach jedoch stets um einen gewissen Betrag größer bleibt als die erwünschte Verstärkerausgangsspannung. Dies kann beispielsweise dadurch geschehen, daß der analogen der Verstärkereingangsspannung proportionalen Spannung ein konstanter Wert hinzuaddiert wird oder dadurch, daß von vornherein die Kennlinie des Analog-Digital-Wandlers entsprechend gewählt wird.

Die Erfindung wird nachstehend anhand der Zeichnung näher erläutert. Es zeigen:

Fig. la und lb den zeitlichen Verlauf von Strom und Spannung an einer Gradientenspulenanordnung,

Fig. 2 eine Ausführungsform der Erfindung,

Fig. 3 die Schaltung des Spannungserzeugers,

Fig. 4 die Endstufe eines Verstärkers für die Gradientenspulenanordnung und

Fig. 5 die Kennlinien des Verstärkers und der Steuerschaltung.

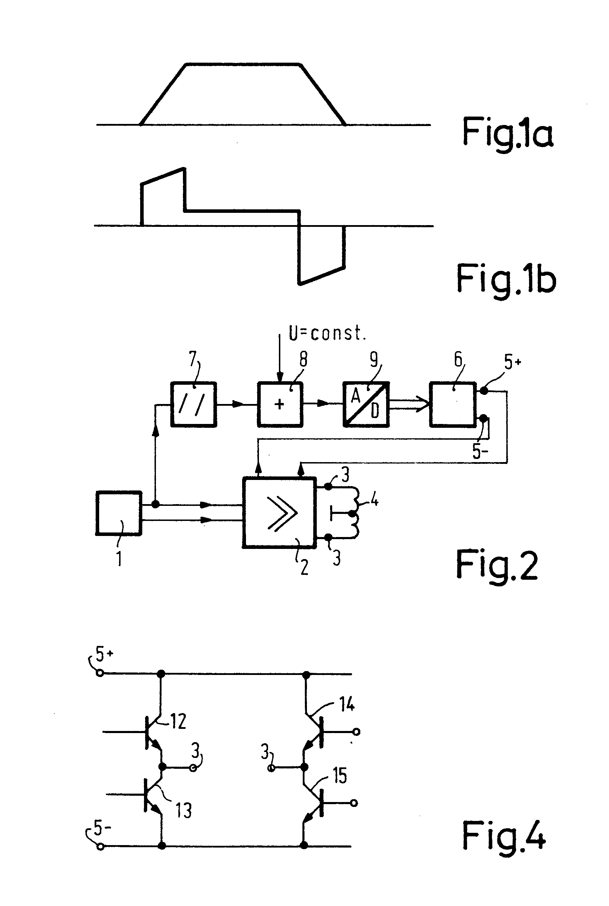

In Fig. 2 ist mit I eine Eingangsstufe bezeichnet, die eine Ausgangsspannung erzeugt, deren zeitlicher Verlauf im wesentlichen dem nach Fig. lb entspricht. Die Schaltung kann einen digitalen Speicher enthalten, in dem der zeitliche Verlauf des magnetischen Flusses gemäß Fig. la an einer Folge von Stützstellen gespeichert ist. Diese Folge wird mittels eines Digital-Analog-Wandlers in ein analoges Signal gemäß Fig. la umgesetzt, woraus dann durch ein analoges Netzwerk der Spannungsverlauf gemäß Fig. lb erzeugt werden kann. Diese Spannung kann an den Ausgangsklemmen der Schaltung I abgegriffen werden, wobei die Spannung an den Ausgängen im Gegentakt und symmetrisch gegen Erde verläuft. Diese Spannung wird einem Verstärker 2 zugeführt, an dessen Ausgangsklemmen 3 eine Gradientenspule 4 angeschlossen ist, deren Mittenanzapfung geerdet ist. Die Versorgungsspannung wird dem Gleichspannungsausgang 5+, 5-eines Spannungserzeugers 6 entnommen, dessen Ausgangsgleichspannung der Spannung am Eingang des Verstärkers derart folgt, daß sie stets um einen gewissen Betrag größer ist als die der Eingangsspannung am Verstärkerausgang zugeordnete Ausgangsspannung.

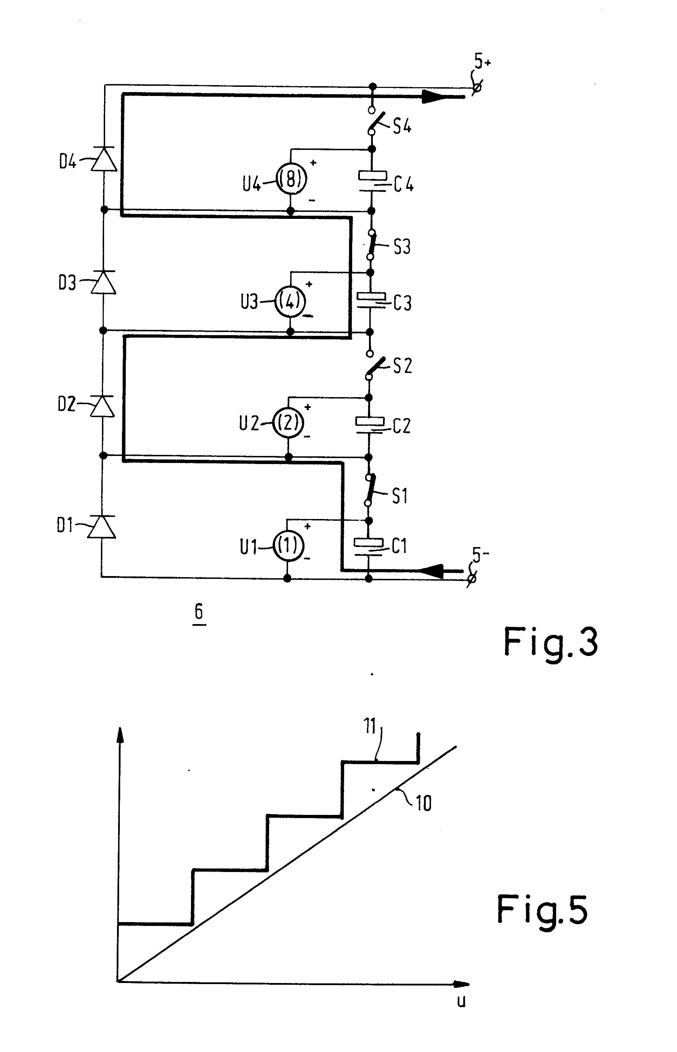

Der Spannungserzeuger 6 ist in Fig. 3 im einzelnen dargestellt. Er besteht aus vier Gleichspannungsquellen $U_1$, $U_2$, $U_3$, $U_4$, die eine Gleichspannung von 5 V, I0 V, 20 V, 40 V liefern, so daß sich ihre Gleichspannungen wie I:2:4:8 verhalten. Jeder der Gleichspannungsquellen $U_1$..$U_4$ ist ein Kondensator $C_1$....$C_4$ parallelgeschaltet, dessen Kapazität so bemessen ist, daß er die Spitzenleistung (während der Spannungsimpulse am Anfang und am Ende) liefern kann. Die Gleichspannungsquellen $U_1$....$U_4$ müssen dann lediglich für die mittlere Leistung ausgelegt sein, wenn sie nur in diesen Phasen für die Versorgungsspannung wirksam sind. Im übrigen bewirken die Kondensatoren eine Glättung.

In Serie zu jeder der Gleichspannungsquellen ist ein elektronisch steuerbarer Schalter $S_1$....$S_4$ geschaltet. Eine Ausgangsklemme 5+ ist mit dem Schalter $S_4$ verbunden, während die Gleichspannungs-Ausgangsklemme 5-mit der Gleichspannungsquelle $U_1$ verbunden ist. Sind mehrere Schalter geschlossen, dann addieren sich die Gleichspannungen der zugehörigen Gleichspannungsquellen. Zwischen die Gleichspannungs-Ausgangsklemmen 5+, 5-ist die Serienschaltung von vier Dioden $D_1$....$D_4$ geschaltet, deren Verbindungspunkt jeweils mit dem gleichartigen Pol der Gleichspannungsquellen $U_1$....$U_4$ verbunden sind. Sind daher einige Schalter geöffnet (in Fig. 3 die Schalter $S_2$ und $S_4$), dann fließt der von den Gleichspannungsquellen $U_1$ und $U_3$, deren Schalter ($S_1$ und $S_3$) geschlossen sind, erzeugte Gleichstrom über die Dioden ($D_2$ und $D_4$), die den unwirksamen Gleichspannungsquellen ($U_2$ und $U_4$) zugeordnet sind. Daraus ergibt sich, daß die Dioden $D_1$....$D_4$ mit gleicher Durchlaßrichtung in Serie geschaltet sein müssen, so daß sie einerseits den von den anderen Gleichspannungsquellen gelieferten Strom durchlassen können und andererseits die zugeordnete Gleichspannungsquelle nicht kurzschließen. Der resultierende Stromverlauf ist in Fig. 3 mit einer stark ausgezogenen Linie angedeutet.

Die Schalteranordnung $S_1...S_4$ wird durch eine Steuerschaltung gesteuert, die aus einer Schaltung 7 zur Betragsbildung, einer Addierstufe 8 und einem Analog-Digital-Wandler 9 bestehen kann. Die Schaltung 7 zur Betragsbildung setzt das dem Verstärker 2 zugeführte Signal in eine Spannung um, die dem Betrag dieses Signals proportional ist. Die Ausgangsspannung dieser Schaltung wird dem einen Eingang einer analogen Addierstufe 8 zugeführt, an deren anderen Addiereingang eine konstante Spannung anliegt, die die gleiche Polarität hat wie das Ausgangssignal der Schaltung 7. Das Ausgangssignal der Addierstufe wird einem Analog-Digital-Wandler 9 zugeführt, der die analoge Eingangsspannung in ein digitales Datenwort umsetzt und damit die Schalteranordnung steuert. Die höchstwertige Binärstelle dieses Datenwortes steuert den Schalter $S_4$, der die Gleichspannungsquelle $U_4$ mit der höchsten Gleichspannung zu- oder abschaltet, die Binärstelle mit der zweithöchsten Wertigkeit steuert den Schalter $S_3$ für die Gleichspannungsquelle $U_3$ mit der zweithöchsten Gleichspannung usw. Wenn der Analog-Digital-Wandler 9 ein Steuersignal mit mehr als vier Binärstellen liefert werden nur die vier höchstwertigen Binärstellen zur Steuerung der Schalter $S_1...S_4$ benutzt.

Die Auslegung der Steuerschaltungen 7, 8, 9, insbesondere die Größe der hinzuzuaddierenden Gleichspannung ergibt sich aus Fig. 5, in der die Abhängigkeit der Ausgangsspannung des Verstärkers (Gerade I0) und der Ausgangsspannung des Gleichspannungserzeugers (Kurve II) als Funktion der Verstärkereingangsspannung u dargestellt ist. Man erkennt, daß sich die Kurve II stets oberhalb der Geraden I0 befindet, und zwar derart, daß die Differenz niemals einen Mindestwert unterschreitet. Dieser Mindestwert ist so bemessen, daß der Verstärker bei jeder Eingangsspannung u in der Lage ist die sich aus der Kennlinie I0 ergebende Ausgangsspannung an den Klemmen 3 zu erzeugen. -Es ist aber auch möglich, die Addierstufe 8 wegzulassen und den Analog-Digital-Wandler von vornherein nichtlinear derart auszulegen, daß sich die Kennlinie gemäß Kurve II von Fig. 5 ergibt.

Wie Fig. Ib zeigt, ändert sich die Polarität der Spannung an der Gradientenspule 4. Der Verstärker muß also so ausgelegt sein, daß er positive und negative Ausgangsspannungen liefern kann. Eine geeignete Ausführungsform der Endstufe eines solchen Verstärkers ist in Fig. 4 dargestellt. Es handelt sich um einen Transistor-Brückenverstärker, der in jedem seiner beiden zwischen die Ausgangsklemmen 5+ und 5-des Spannungserzeugers 6 geschalteten Brückenzweige die Serienschaltung zweier npn-Transistoren I2 und I3 bzw. I4 und I5 enthält. Die Transistorbrücke wird so gesteuert. daß die Spannung zwischen den Basen zweier in Serie geschalteter Transistoren im wesentlichen konstant bleibt und daß die Potentiale an den Basen der Transistoren I2 und I3 und I4 und I5 andererseits im Gegentakt geändert werden. Die dazu erforderlichen Treiber-und gegebenenfalls Vorverstärkerstufen können an die vom Spannungserzeuger 6 gelieferte Versorgungsspannung angeschlossen werden. Jedoch ist auch der Anschluß an einen getrennten Gleichspannungserzeuger möglich.

Vorstehend wurde von einer Schaltungsanordnung mit einer Gradientenspule ausgegangen, wie sie Teil eines Kernspintomographen sein kann. Die Erfindung ist jedoch auch davon unabhängig in all den Fällen anwendbar, in denen es um die Verringerung der Verlustleistung eines Verstärkers geht, insbesondere bei induktiver oder kapazitiver Last.

In der Regel kann die Versorgungsspannung einer Änderung der Eingangsspannung nicht so - schnell folgen wie die Ausganspannung des Verstärkers. Deshalb können sich am Ausgang des Verstärkers Verzerrungen ergeben, wenn die Eingangsspannung zunimmt. Bei einem Kernspintomographen stören solche kurzzeitig auftretenden Verzerrungen _ nicht. Bei Anwendungen, bei denen diese Verzerrungen nicht hingenommen werden können, könnte die Eingangsspannung dem Verstärker über ein Verzögerungsglied zugeführt werden, so daß die Versorgungsspannung gegebenenfalls schon erhöht ist, wenn die Verstärkereingangsspannung eine größere Versorgungsspannung erforderlich macht. Um zu verhindern, daß die Versorgungsspannung absinkt, bevor das Eingangssignal entsprechend abgenommen hat, könnte die Steuerschaltung bzw. der Gleichspannungserzeuger so betrieben werden, daß sich bei Spannungserhöhungen eine kleine Zeitkonstante und bei Spannungsabsenkungen eine große Zeitkonstante ergibt.

**Ansprüche**

1. Schaltungsanordnung mit einer an den Ausgang eines Verstärkers angeschlossenen Last und einem Spannungserzeuger, der an seinem Gleichspannungsausgang die Versorgungsspannung zumindest für die Endstufe des Verstärkers liefert,

dadurch gekennzeichnet, daß der Spannungserzeuger (6) mehrere Gleichspannungsquellen ($U_1..U_4$) mit unterschiedlich großer Gleichspannung enthält sowie eine Schalteranordnung ($S_1...S_4$), die eine der Gleichspannungsquellen oder die Serienschaltung mehrerer Gleichspannungsquellen mit dem Gleichspannungsausgang (5+, 5-) verbindet, und daß eine Steuerschaltung (7, 8, 9)vorgesehen ist, die aus dem Eingangssignal (u) des Verstärkers eine Steuerspannung zur Steuerung der Schalteranordnung ableitet in solcher Weise, daß die Spannung am Gleichspannungsausgang der Eingangsspannung in Stufen folgt, jedoch stets um einen gewissen Betrag größer bleibt als der Betrag der mit dem Verstärkungsfaktor des Verstärkers multiplizierten Eingangsspannung.

2. Schaltungsanordnung nach Anspruch I,

dadurch gekennzeichnet, daß die Schalteranordnung für jede Gleichspannungsquelle (U$_1$ ..U$_4$) einen dazu in Serie geschalteten Schalter (S$_1$ ..S$_4$) umfaßt und daß jeder dieser Serienschaltungen eine Diode (D$_1$...D$_4$) parallelgeschaltet ist, die für die zugehörige Gleichspannungsquelle in Sperrichtung betrieben ist.

3. Schaltungsanordnung nach einem der Ansprüche I oder 2,

dadurch gekennzeichnet, daß jeder Gleichspannungsquelle (U$_1$..U$_4$) ein Kondensator (C$_1$...C$_4$) parallelgeschaltet ist.

4. Schaltungsanordnung nach einem der Ansprüche I bis 3,

dadurch gekennzeichnet, daß die Gleichspannungen jeder Gleichspannungsquelle jeweils doppelt bzw. halb so groß ist wie die nächstkleinere bzw. nächstgrößere Gleichspannung einer anderen Gleichspannungsquelle.

5. Schaltungsanordnung nach Anspruch 4,

dadurch gekennzeichnet, daß die Steuerschaltung einen Analog-Digital-Wandler (9) enthält, der ein aus dem Verstärkereingangssignal (u) abgeleitetes Signal in ein binär codiertes Datenwort umsetzt, dessen höchstwertige Binärstellen das Steuersignal bilden, wobei jeweils die höherwertige Binärstelle die Einschaltung der Gleichspannungsquelle mit der höheren Gleichspannung bewirkt.

6. Schaltungsanordnung nach einem der vorhergehenden Ansprüche,

gekennzeichnet durch ihre Verwendung in einem Kernspintomographen, deren Gradientenspulenanordnung (4) die Last des Verstärkers (2) bildet.

Fig.1a

Fig.1b

U=const.

Fig.2

Fig.4

Fig.3

Fig.5

2-Ⅱ- PHD 85-124